# EUROPEAN PATENT SPECIFICATION

(11) **EP 0 347 906 B1**
(45) Date of publication and mention of the grant of the patent: **17.04.1996**
(21) Application number: 89111371.4
(22) Date of filing: 22.06.1989
(51) Int. Cl.: G01R 31/28, G06F 11/26

(54) **Self-diagnostic circuit for logic circuit block**
Selbstdiagnoseschaltung für einen logischen Schaltungsblock
Circuit d'autodiagnostic pour bloc de circuit logique

(30) Priority: 22.06.1988 JP 154017/88
(43) Date of publication of application: 27.12.1989
(73) Proprietor: KABUSHIKI KAISHA TOSHIBA, Kawasaki-shi, Kanagawa-ken 210, Tokyo (JP)
(72) Inventor: Nozuyama, Yasuyuki, Tokyo (JP); Nishimura, Akira 13-21, Kubocho, Yokohama-shi Kanagawa-ken (JP)
(74) Representative: Lehn, Werner, Dipl.-Ing.

(56) References cited:
- EP-A- 0 181 011
- GB-A- 1 536 147
- GB-A- 2 022 319
- US-A- 4 710 931

## Description

### BACKGROUND OF THE INVENTION

### 1. Field of the Invention

The present invention relates to a self diagnostic circuit.

### 2. Description of the related Art

It is general to incorporate a diagnostic circuit in a VLSI (very large scale integrated circuit) to self-diagnose logic circuit blocks of the VLSI with a simple signal given externally to the diagnostic circuit. As VLSIs become more integrated, complicated and high functional, a self-diagnostic system that can diagnose such a VLSI more easily is required.

From G3 2 022 319 A an integral test circuit for a very large scale integrated circuit is known. The test circuit includes a counter, a combination circuit and a plurality of selection switches. The circuit is used to multiplex a small number of test pads to provide testing facilities for the associated integrated circuit. The selection switches selectively connect test pads inside the integrated circuit with an output terminal of the device.

Generally, a self-diagnostic system for diagnosing a logic circuit is based on signature analysis. An output register of a circuit block to be diagnosed forms a linear feedback shift register (LFSR). A test pattern generator generates test patterns, which are applied to the circuit block to be diagnosed. Outputs of the circuit block are sequentially applied to the LFSR. This operation is called "signature compression". After the completion of a predetermined diagnostic sequence, the contents (signature of diagnosis) of the LFSR are compared with predetermined values to automatically diagnose the quality of the circuit block.

There are various forms of judging a result of self-diagnosis. For example, as described in the above, a VLSI chip incorporating a self-diagnostic circuit may have a comparison circuit that compares a result of self-diagnosis with a predetermined value. A self-diagnostic result based on the comparison is represented with a simple quality signal that is outputted to an upper level controller or to the outside of the VLSI chip.

Since it is not always necessary to implement the predetermined value on the chip, the self-diagnostic result may be stored in a register that is readable from the outside of the chip. Then, the quality judgment is carried out under higher level control such as machine language instruction program control, or with the use of an LSI tester.

The register for storing the self-diagnostic result may be a register different from output registers of the circuit blocks that have been self-diagnosed, or the output registers of the circuit blocks that constitute an LFSR at the time of self-diagnosis may themselves be used as means for storing the diagnostic result. The reason of this is because the contents (signature) of the LFSR represent histories of patterns applied in the self-diagnosis. Therefore, it is common to use the output registers of the circuit blocks to be diagnosed as the means for storing the diagnostic result.

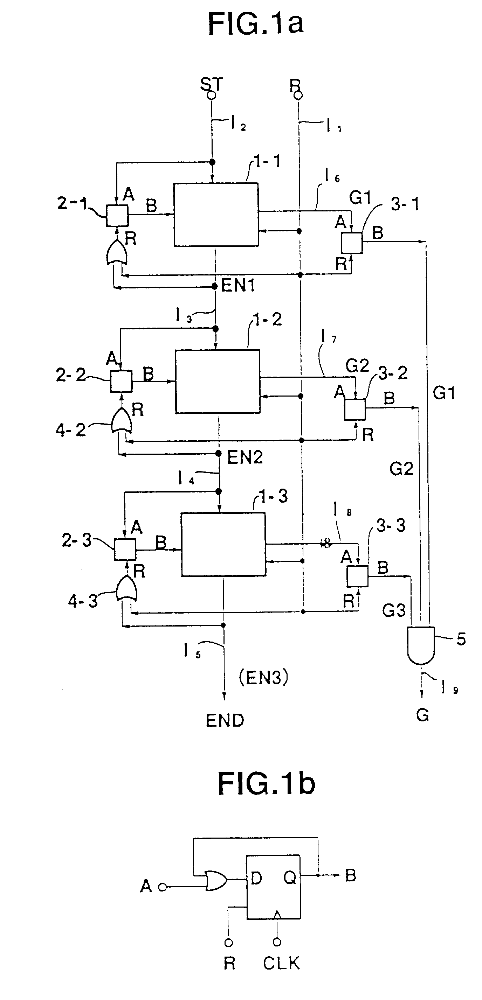

Figure 1a is a block diagram showing a self-diagnostic circuit taken as a basis for the present invention. It comprises circuit blocks 1-1, 1-2 and 1-3 to be diagnosed, flip-flops (FFs) 2-1, 2-2 and 2-3 each of which indicates whether or not the diagnosis is being carried out, flip-flops (FFs) 3-1, 3-2 and 3-3 for storing diagnosis resultant data, OR gates 4-1, 4-2 and 4-3, and an AND gate 5.

In Fig. 1a, a reset signal R is inputted through an input line lₗ, and a start signal ST is inputted through an input line ℓ₂. End signals EN₁, EN₂ and EN₃ are outputted through output lines ℓ₃, ℓ₄ and ℓ₅. "GOOD" resultant signals are outputted through lines ℓ₆, ℓ₇ and ℓ₈. A self-diagnosis "GOOD" resultant signal G is outputted through a line ℓ₉.

Each of the FFs 2-1 to 2-3 and 3-1 to 3-3 is a D-type FF as shown in Fig. 1b. According to a clock signal CLK, the FF latches "GOOD" resultant signals (G₁, G₂, G₃) provided through a terminal A. Further, according to the clock signal CLK, the FF outputs the latched start signal ST, end signals EN₁, EN₂, and "GOOD" resultant signals (G₁, G₂, G₃) through a terminal B. The clock signal CLK is not shown in Fig. 1a.

To carry out the self-diagnosis in the arrangement of Fig. 1a, the reset signal R (=1) is given to the blocks 1-1 to 1-3 through the line ℓ₁ to initialize the circuit as a whole. Then, the FFs 2-1 to 2-3 and 3-1 to 3-3 are all reset. AT the same time, input registers, output registers, counters, etc., that are incorporated in the circuit blocks 1-1 to 1-3 but not shown in the figure are reset.

After that, the reset signal R is returned to 0. The start signal ST (=1) is given through the line ℓ₂ so that the diagnosis may be started from the circuit block 1-1. A terminal B of the FF 2-1 outputs the signal of 1 to self-diagnose the circuit block 1-1 according to a signature analyzing method, etc.

After the completion of the diagnosis of the circuit block 1-1, the block 1-1 outputs the end signal EN₁ and "GOOD" resultant signal G₁. Here, "G₁=1" represents "GOOD" while "G₁=0" represents "NO GOOD." The same will be applied to the signals G₂ and G₃. Then, the resultant signal G₁ is latched by the FF 3-1, and the end signal EN₁ resets the FF 2-1 and starts the self-diagnosis of the circuit block 1-2.

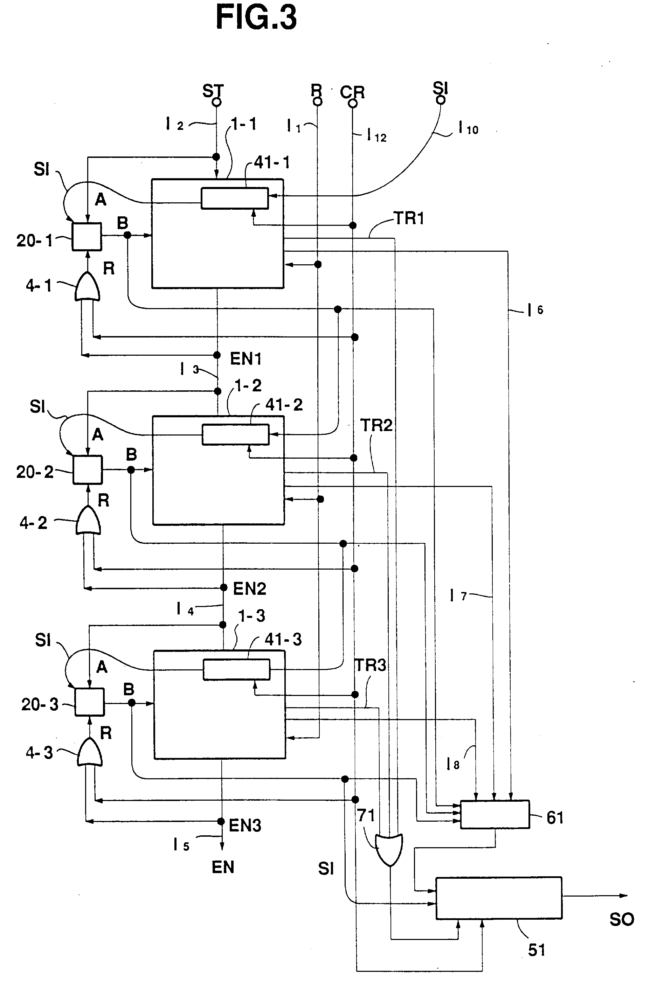

In this way, the circuit blocks 1-1 to 1-3 are sequentially diagnosed. The "GOOD" resultant signals G₁, G₂ and G₃ are sequentially latched by the FFs 3-1 to 3-3. Unless the reset signal R is inputted, the statuses of the FIG 3-1 to 3-3 are kept as they are. The contents of the FFs 3-1 to 3-3 are given to the AND gate 5.

The self-diagnosis end signal EN₃ of the circuit lock 1-3 will be an overall self-diagnosis end signal. This end signal EN 3 and an overall "GOOD" resultant signal G (G₁ G₂ G₃) are sent to an upper level control block (not shown) in the VLSI to complete the self-diagnostic operation.

The upper level control block judges that all the circuit blocks that have been self-diagnosed are normal if G=1 (i.e., G₁=1, G₂= and G₃=1), while the upper level control block judges that some of the circuit blocks are faulty if G=0.

There are many forms of self-diagnosis other than the conventional example mentioned in the above. For example, an output register of a certain circuit block to be self-diagnosed may commonly be used as an input register of the next circuit block to be diagnosed. If there are many (N pieces) circuit blocks to be self-diagnosed, it is not necessary to provide a diagnosis execution indicating flip-flop (FF) for each of the N circuit blocks. Instead, it is possible to decode outputs of about log₂N pieces of FFs to indicate the execution of diagnosis. It is also possible to use only one FF to indicate the parallel execution of self-diagnoses of a plurality of circuit blocks. These superficial variations are not essential to the present invention, and the present invention is applicable to these variations.

According to the conventional self-diagnostic system described in the above, the circuit blocks are sequentially diagnosed. Namely, they are diagnosed in a go-or-no-go way. Accordingly, the system is not appropriate for analyizing the quality of complicated logic circuits and not sufficient to carry out a complicated self-diagnosis.

In addition, the diagnostic system cannot directly select a specific one among circuit blocks but it shall sequentially diagnose all the circuit blocks including the specific one.

As VLSIs become further integrated, complicated and highly functional, the self-diagnostic sequence is unavoidably complicated and expanded. Therefore, if the diagnostic sequence is disturbed in a certain block, diagnoses of the following blocks may be hindered to cause a serious problem.

### SUMMARY OF THE INVENTION

To solve the problem mentioned in the above, an object of the present invenion is to provide a VLSI circuit with a self-diagnostic system that can select a specific one among circuit blocks to diagnose the specific circuit block to effectively diagnose a plurality of the circuit blocks.

In order to accomplish the object, the present invention provides a self-diagnostic circuit comprising: a plurality of logic circuit blocks (1-1, ..., 1-3) to be diagnosed; a plurality of first storage portions (20-1, ..., 20-3), each first storage portion being coupled to a respective logic circuit block and having an output indicating that said respective logic circuit to which it is coupled is to perform a self-diagnosis operation; a plurality of second storage portions (30-1, ..., 30-3), each second storage portion being coupled to a respective logic circuit block (1-1, ..., 1-3) for storing diagnostic results of said respective logic circuit blocks; a scanning path, including said plurality of first (20-1, ..., 20-3) and second (30-1, ..., 30-3) storage portions and means for selectively enabling particular logic circuit blocks, to perform a sequential diagnostic operation mode in which said logic circuit blocks (1-1, ..., 1-3) are sequentially diagnosed, and a selective diagnosis mode in which specific logic circuit block is selectively diagnosed if a logical value of a diagnosis starting signal is supplied and scan in data for seectively diagnosing the specific circuit block have been supplied under a scan-in operation mode.

The self-diagnostic circuit comprises a plurality of circuit blocks to be diagnosed, a plurality of first storage portions provided for indicating the execution of diagnosis of the circuit blocks, and second storage portions for storing results of diagnoses of the circuit blocks. The first and second storage portions and circuit blocks have a sequential diagnostic operation mode in which the circuit blocks are sequentially diagnosed according to a diagnosis starting signal, and a selective diagnosis mode in which a specific one among the circuit blocks is selected and diagnosed. The selective diagnosis mode is realized after supplying the logical value of the diagnosis starting signal and scan-in data with which the specific circuit block is separately selected and diagnosed, using a scan operation mode.

The first and second storage portions and circuit blocks are connected in a predetermined order in a scan chain circuit. In the scan operation mode, the storage portions and circuit blocks in the scan chain circuit are scanned, and data for selectively starting the diagnosis of the specific circuit block or selectively putting the specific circuit block under an execution state are set in the first and second storage portions and circuit blocks to selectively diagnose the specific circuit block.

These and other objects, features and advantages of the present invention will be more apparent from the following detailed description of preferred embodiments in conjunction with the accompanying drawings.

### BRIEF DESCRIPTION OF THE DRAWINGS

Fig. 1a is a block diagram showing a self-diagnostic circuit according to a related art;
Fig. 1b is a schematic diagram a flip-flop (FF) shown in Fig. 1a;
Fig. 2a is a block diagram showing a self-diagnostic circuit according to an embodiment of the invention;
Fig. 2b is a schematic diagram showing a flip-flop (FF) shown in Fig. 2a; and
Fig. 3 is a block diagram showing a modification of the self-diagnostic circuit of the invention.

### DETAILED DESCRIPTION OF THE EMBODIMENTS

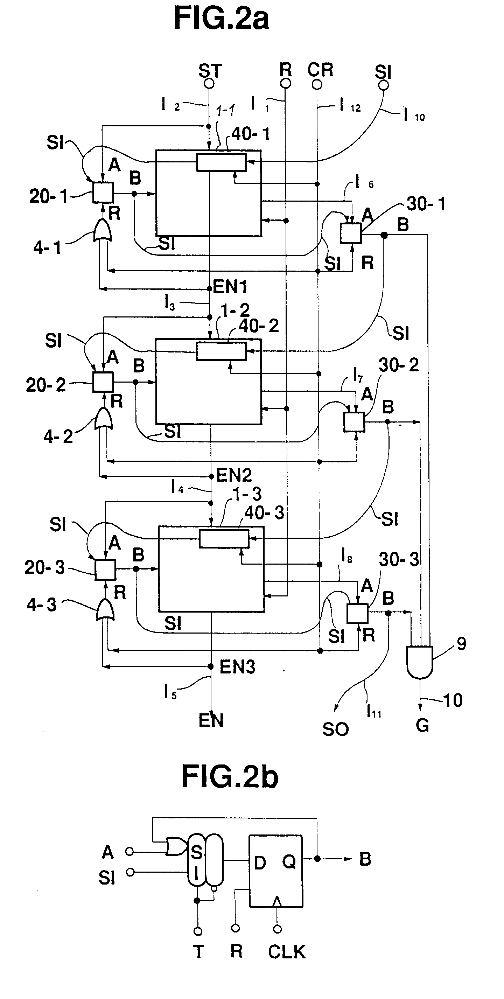

Figure 2a is a block diagram showing a self-diagnostic circuit according to an embodiment realizing a self-diagnostic method of the invention. Figure 2b is a view showing the details of a flip-flop (FF) shown in Fig. 2a.

In Fig. 2a, the self-diagnostic circuit comprises circuit blocks 1-1 to 1-3 to be diagnosed, flip-flops (FFs) 20-1 to 20-3 each indicating whether or not a diagnosis is under execution, flip-flops (FFs) 30-1 to 30-3 each storing diagnosis resultant data, OR gates 4-1 to 4-3, and an AND gate 9. The circuit blocks 1 1 to 1 3 incorporate circuits 40-1 to 40-3, respectively. Each of the circuits 40-1 to 40-3 comprises a diagnostic input pattern generating circuit and an end signal generating circuit that outputs an end signal (EN₁, EN₂ or EN₃) for indicating the end of a diagnostic sequence.

In addition to the sequential diagnostic operation mode explained with reference to Fig. 1a of the prior art, the embodiment has a selective diagnosis mode for selectively diagnosing a specific circuit block. To realize the selective diagnosis mode, there is a scan operation mode. The FFs 20-1 to 20-3, FFs 30-1 to 30-3 and diagnostic input pattern generating and end signal generating circuits 40-1 to 40-3 are scanned according to a selection signal comprising a scan operation mode signal T to be described later to set the FFs and diagnostic input pattern generating and end signal generating circuits so that, after the scan operation mode is turned off, a specific one of the circuit blocks 1-1 to 1-3 will selectively be diagnosed.

Each of the FFs 20-1 to 20-3 and 30-1 to 30-3 is constituted as shown in Fig. 2b. When the scan operation mode signal T is 0, the FFs operate in the same manner as the D-type FFs shown in Fig. 1b. When the scan operation mode signal T is 1, the FFs receive the scan-in data SI and output the scan in data SI from terminals B of the FFs at the rising edge of the clock signal CLK.

In connection with the FF shown in Fig. 2b, if the scan-in data SI is 1 with the scan operation mode signal T being 1 and if the clock signal CLK is changed from 0 to 1, the FF will take in the value 1 of the scan-in data SI, and it hold the value (SI=1) if the scan operation mode signal T is changed to 0 before the clock signal CLK is next changed from 0 to 1. Then, a circuit block corresponding to the FF (20-1, 20-2 or 20-3) that is holding the value 1 will be diagnosed.

To scan the FFs and circuit blocks with the scan-in data SI, a scan chain circuit connects the FFs and circuit blocks in the order of the diagnostic input pattern generating and end signal generating circuit 40-1, FF 20-1, FF 30-1, the diagnostic input pattern generating and end signal generating circuit 40-2, FF20-2, FF 30-2, the diagnostic input pattern generating and end signal generating circuit 40-3, FF 20-3 and FF 30-3.

Unlike the prior art shown in Fig. 1a, the embodiment employs two kinds of reset signals. Namely, a signal CR resets or initializes the FFs 20-1 to 20-3 and 30-1 to 30-3 and the diagnostic input pattern generating and end signal generating circuits 40-1 to 40-3 included in the scan chain, and a reset signal R initializes or resets the circuit blocks 1-1 to 1-3 to start the self-diagnosis.

Like numerals represent like elements and like input/output lines in Figs. 1a and 2a. The circuit of the embodiment shown in Fig. 2a additionally includes a line ℓ₁₀ for inputting the scan-in data SI, a liner ℓ₁₁ for outputting a scan-out data SO, and a line ℓ₁₂ for inputting the reset signal CR.

In Fig. 2a, the terminals shown in Fig. 2b for inputting the scan operation mode signal T and clock signal CLK are not shown for the sake of simplicity.

Operation of the embodiment will be explained.

When the scan operation mode signal T is set to 0 and when the reset signals R and CR are simultaneously turned on, i.e., set to 1 to initialize the circuit as a whole. After that these signals are again turned off. Then, a starting signal ST may be set to 1 to start the self-diagnostic sequence. Under this situation, similar to the prior art shown in Fig. la, the circuit blocks 1-1 to 1-3 are sequentially diagnosed. Since the operation is the same as that of the art shown in Fig. 1a it will not be repeatedly explained.

In addition to the sequential diagnosis, the present invention is capable of diagnosing a particular one of the circuit blocks, for instance, the circuit block 1-3. This will be explained.

The scan operation mode signal T supplied to each of the FFs 20-1 to 20-3 and 30-1 to 30-3 and diagnostic input pattern generating and end signal generating circuits 40-1 to 40-3 is set to 1 to establish the scan operation mode. The reset signal R is set to 1 and signal CR to 0 to required scan-in data SI be supplied from the outside for every clock cycle through the line l₁₀. The scan-in data SI sequentially scan the diagnostic input pattern generating and end signal generating circuits 40-1 to 40-3 and FFs 20-1 to 20-3 and 30-1 to 30-3 in the order of the scan chain mentioned before. When the FFs 20-1 to 20-3 are set to 0, 0 and 1, respectively, the FFs 30-1 to 30-3 to 1, 1 and 0, respectively, and the diagnostic input pattern generating and end signal generating circuits 40-1 to 40-3 to proper initial values, the scan operation mode signal T may be set to 0 so that those values are held in the FFs 20-1 to 20-3 and 30-1 to 30-3 and diagnostic input pattern generating and end signal generating circuits 40-1 to 40-3. Particularly, the FF 20-3 will hold the value of 1. Then, the self-diagnosis of the circuit block 1-3 corresponding to the FF 20-3 is carried out. A diagnosis "GOOD" resultant signal G₃ from the circuit block 1-3 is fetched by the FF 30-3. Since the FFs 30-1 and 30-2 have held each 1, the signal G₃ from an output of the FF 30-3 will cause the AND gate 9 to output an overall diagnosis "GOOD" resultant signal G.

In this way, the embodiment can freely set various input signals to diagnose each circuit block independently of the other circuit blocks. A result of each diagnosis is easily understood by carrying out a predetermined number of diagnostic clock cycles having been set under the scan operation mode and by checking the signal G that indicates a result of the diagnosis.2

In the embodiment, the FFs 30-1 to 30-3 have been employed to store results of diagnoses. Instead of the FFs 30-1 to 30-3, a register may be employed to store more detailed results of diagnoses. Just after the completion of self-diagnosis of each circuit block, a value of an output register or of a part of it, of the diagnosed circuit block may be transferred to the register that substitutes for the FFs, to store a result of the diagnosis therein. In this case, the lines l₆, l₇ and l₈ may be diagnostic result transfer lines (single or plural), and the FFs 30-1 to 30-3 may be diagnostic result storing registers.

In the above case, it is preferable to read the contents ("GOOD" signals G₁ to G₃ each represented by an array of plural bits) of the respective registers separately. It is not meaningful to make a simple "GOOD" signal from G₁ to G₃, as was seen in the art shown in Fig.1a.

If the diagnostic result storing means is a register, the AND gate 9 is not needed. This register for storing the diagnostic result may be a normal register or may be an LFSR having serial or parallel inputs. If the LFSR is used, results of all diagnoses can be handled with the single register.

Figure 3 is a view showing another embodiment of the invention, in which the diagnostic result storing means is a linear feedback shift register (LFSR) 51 with serial inputs. In this embodiment, results of diagnoses of respective circuit blocks are transferred to the LFSR 51 that is a storage for storing a final overall diagnostic result. A result of diagnosis of each circuit block is expressed with the contents (plural bits) of an output register of the circuit block in question. The transfer operation to the LFSR 51 is achieved in plural clock cycles. Due to this, a diagnostic result transfer signal generating circuit is needed in addition to an end signal generating circuit. In Fig, 3, these two kinds of circuits and a diagnostic input pattern generating circuit are contained in each of circuits represented with numerals 41-1 to 41-3. Diagnostic result transfer signals of the circuit blocks are represented with reference marks TR₁ to TR₃, respectively. Reference marks l₆ to l₈ are transfer lines of the diagnostic results of the circuit blocks.

These transfer signals shall become 1 during a time period necessary for the transfer to activate writing operation with respect to the LFSR 51. Generally, this requires very small circuit addition. For example, if a diagnostic input pattern is provided by a count-up counter, a combination signal of proper bits of the counter or an overflow signal of the counter is generally used as an end signal, and also a transfer signal may be generated in the same manner.

A selector 61 of Fig. 3 selects data to be taken in the LFSR from the transfer lines. A selection signal for the selector 61 is an output of a flip-flop (FF) that indicates an execution state of each diagnosis. (It is possible to omit some of the outputs of the FFs). Therefore, in this embodiment, signals EN₁ to EN₃ that indicate the completion of respective diagnoses are activated after the completion of transfer of results of the diagnoses. To enable read operation with a scan operation mode signal T=1, a feedback loop of the LFSR 51 is electrically cut off with the scan operation mode signal T (=1) so that the LFSR 51 may become a register that allows a normal scan operation. The signal T is not shown in Fig. 3.

The self-diagnostic according to the invention is applicable for logic circuit blocks that are controllable with microinstructions. The self-diagnosis under the control of microinstructions is somewhat special because a plurality of circuit blocks are diagnosed with a group of diagnostic microinstruction sequences. This technique basically requires only one flip-flop (FF) to indicate an overall execution state of the microinstruction diagnosis. Diagnosis of one circuit block may be distinguished from diagnoses of the other circuit blocks if the diagnostic microinstruction sequences are so formed to be clearly distinguished from each other. In this case, if initialization of each diagnostic sequence is done in first several steps of the sequence, it is more easy to distinguish the sequences from each other.

With this sort of arrangement of the diagnostic microinstruction sequences, an address input register of a ROM for storing the microinstructions is constituted to be scanned. Then, a first address of certain diagnostic microinstruction sequences for a certain circuit block may be set according to scanning operation. By executing the certain microinstruction sequence, the certain circuit block can be diagnosed independently of the other circuit blocks. A temporal length of executing self-diagnosis of each microinstruction sequence is determined by the number of microloops. Namely, a microloop counter corresponds to a completion judging circuit of the diagnosis of each circuit block. If the microloop counter is made to be scanned, it is possible to control the completion judging circuit.

## Claims

1. A self-diagnostic circuit comprising:
a plurality of logic circuit blocks (1-1, ..., 1-3) to be diagnosed;
a plurality of first storage portions (20-1, ..., 20-3), each first storage portion being coupled to a respective logic circuit block and having an output indicating that said respective logic circuit to which it is coupled is to perform a self-diagnosis operation;
a plurality of second storage portions (30-1, ..., 30-3), each second storage portion being coupled to a respective logic circuit block (1-1, ..., 1-3) for storing diagnostic results of said respective logic circuit blocks;
a scanning path, including said plurality of first (20-1, ..., 20-3) and second (30-1, ..., 30-3) storage portions and means for selectively enabling particular logic circuit blocks, to perform a sequential diagnostic operation mode in which said logic circuit blocks (1-1, ..., 1-3) are sequentially diagnosed, and a selective diagnosis mode in which a specific logic circuit block is selectively diagnosed if a particular logical value of a diagnosis starting signal is supplied and scan in data for selectively diagnosing the specific circuit block have been supplied under a scan-in operation mode.

2. The self-diagnostic circuit as claimed in claim 1, wherein each of said logic circuit blocks (1-1, ..., 1-3) is provided with a diagnostic input pattern generating and end signal generating circuit (40-1, ..., 40-3) that can be set to a diagnostic operation status according to a scan-in data for selectively diagnosing said particular logic circuit block.

3. The self-diagnostic circuit as claimed in claim 2, further comprising:
a scan chain circuit for connecting said first and second storage portions and said logic circuit blocks in a predetermined order,
means for carrying out a scan operation mode through said scan chain circuit and for setting data in said first (20-1, ..., 20-3) and second (30-1, ..., 30-3) storage portions and in the diagnostic input pattern generating and end signal generating circuits (40-1, ..., 40-3) such that a particular one of said logic circuit blocks will be selectively diagnosed, and then, for releasing said scan operation mode.

4. The self-diagnostic circuit as claimed in claim 1, wherein each of said logic circuit blocks (1-1, ..., 1-3) has a diagnostic input pattern generating and end signal generating circuit (40-1, ..., 40-3) each logic circuit block being diagnosed according to the end signal sent from another of said logic circuit blocks (1-1, ..., 1-3) arranged in front of the logic circuit block in question;
said first (20-1, ..., 20-3) and second (30-1, ..., 30-3) storage portions select input signals to be held therein according to a scan operation mode signal; and
a scan chain circuit is provided for connecting said first and second storage portions and said diagnostic input pattern generating and end signal generating circuits (40-1, ..., 40-3) in a predetermined order,
scan-in data is supplied through said scan chain circuit to said first and second storage portions and said diagnostic input pattern generating and end signal generating circuits to set data to the said storage portions and said diagnostic input pattern generating and end signal generating circuits,
after desired data having been set to said first (20-1, ..., 20-3) and second (30-1, ..., 30-3) storage portions and said diagnostic input pattern generating and end signal generating circuits (40-1, ..., 40-3), the scan operation mode signal is released, thus selectively diagnosing a specific one of said logic circuit blocks.

5. A self-diagnostic circuit as claimed in claim 1, wherein each of said logic circuit blocks has a diagnostic input pattern generating, end signal generating and diagnostic result transfer signal generating circuit (41-1, ..., 41-3), each logic circuit block being diagnosed according to the end signal sent from another of said circuit blocks arranged in front of the circuit block in question;
said first storage portion (20-1, ..., 20-3) selects input signals to be held therein according to a scan operation mode signal (T);
said second storage portion (51) comprises a linear feedback shift register with serial inputs; and
a scan chain circuit is provided for connecting said first storage portions (20-1, ..., 20-3) and said diagnostic input pattern generating, end signal generating and diagnostic result transfer signal generating circuits (41-1, ..., 41-3) in a predetermined order,
scan-in data is supplied through said scan chain circuit to set data to said first storage portion (20-1, ..., 20-3) and said diagnostic input pattern generating, end signal generating and diagnostic result transfer signal generating circuits (41-1, ..., 41-3),
after desired data have been sent to said first storage portion (20-1, ..., 20-3) and said diagnostic input pattern generating, end signal generating and diagnostic result transfer signal generating circuits (41-1, ..., 41-3), the scan operation mode signal (T) is released, and the results of diagnoses of respective circuit blocks are transferred to said second storage portion (51), thus selectively diagnosing a specific one of said circuit blocks.

## Patentansprüche

1. Selbstdiagnoseschaltkreis mit:
einer Vielzahl von Logikschaltungsblöcken(1-1, ..., 1-3), die zu diagnostizieren sind;
einer Vielzahl von ersten Speicherabschnitten (20-1, ..., 20-3), wobei jeder erste Speicherabschnitt mit einem jeweiligen Logikschaltungsblock gekoppelt ist und einen Ausgang aufweist, welcher anzeigt, daß der jeweilige Logikschaltkreis, mit welchem er gekoppelt ist, einen Selbstdiagnosevorgang ausführen soll;
einer Vielzahl von zweiten Speicherabschnitten (30-1, ..., 30-3), wobei jeder zweite Speicherabschnitt mit einem jeweiligen Logikschaltungsblock (1-1, ..., 1-3) gekoppelt ist, zum Speichern von Diagnoseergebnissen der jeweiligen Logikschaltungsblöcke;
einem Abtastpfad, einschließlich der Vielzahl von ersten (20-1, ..., 20-3) und zweiten (30-1, ..., 30-3) Speicherabschnitten und Einrichtungen zum selektiven Aktivieren spezieller Logikschaltungsblöcke, um einen Betriebsmodus sequentieller Diagnose durchzuführen, in welchem die Logikschaltungsblöcke (1-1, ..., 1-3) sequentiell diagnostiziert werden, und einen Modus selektiver Diagnose, in welchem ein spezifischer Logikschaltungsblock selektiv diagnostiziert wird, wenn ein spezieller logischer Wert eines Diagnosestartsignals geliefert wird und Einlesedaten zum selektiven Diagnostizieren des spezifischen Schaltungsblockes unter einem Einlesebetriebsmodus geliefert worden sind.

2. Selbstdiagnoseschaltkreis nach Anspruch 1, dadurch gekennzeichnet, daß jeder der Logikschaltungsblöcke (1-1, ..., 1-3) mit einem Diagnoseeingangsmustererzeugungs- und Endsignalerzeugungsschaltkreis (40-1, ..., 40-3) versehen ist, der gemäß Einlesedaten in einen Diagnosebetriebszustand gesetzt werden kann, um selektiv den speziellen Logikschaltungsblock zu diagnostizieren.

3. Selbstdiagnoseschaltkreis nach Anspruch 2, gekennzeichnet durch
einen Abtastkettenschaltkreis zum Verbinden der ersten und zweiten Speicherabschnitte und der Logikschaltungsblöcke in einer vorbestimmten Reihenfolge,
Einrichtungen zum Durchführen eines Abtastbetriebsmodus durch den Abtastkettenschaltkreis und zum Einstellen von Daten in den ersten (20-1, ..., 20-3) und zweiten (30-1, 30-3) Speicherabschnitten und in den Diagnoseeingangsmustererzeugungs- und Endsignalerzeugungsschaltkreisen (40-1, ..., 40-3), so daß ein spezieller der Logikschaltungsblöcke selektiv diagnostiziert wird, und dann, zum Verlassen des Abtastbetriebsmodus.

4. Selbstdiagnoseschaltkreis nach Anspruch 1, dadurch gekennzeichnet, daß jeder der Logikschaltungsblöcke (1-1, ..., 1-3) einen Diagnoseeingangsmustererzeugungs- und Endsignalerzeugungsschaltkreis (40-1, ..., 40-3) aufweist und jeder Logikschaltungsblock gemäß dem Endsignal diagnostiziert wird, das von einem anderen der Logikschaltungsblöcke (1-1, ..., 1-3) gesendet wird, die vor dem fraglichen Logikschaltungsblock angeordnet sind;
die ersten (20-1, ..., 20-3) und zweiten (30-1, ..., 30-3) Speicherabschnitte darin zu haltende Eingangssignale gemäß einem Abtastbetriebsmodussignal auswählen; und
ein Abtastkettenschaltkreis zum Verbinden der ersten und zweiten Speicherabschnitte und der Diagnoseeingangsmustererzeugungs- und Endsignalerzeugungsschaltkreise (40-1, ..., 40-3) in einer vorbestimmten Reihenfolge vorgesehen ist,
Einlesedaten durch den Abtastkettenschaltkreis an die ersten und zweiten Speicherabschnitte und die Diagnoseeingangsmustererzeugungs- und Endsignalerzeugungsschaltkreise geliefert werden, um Daten an die Speicherabschnitte und die Diagnoseeingangsmustererzeugungs- und Endsignalerzeugungsschaltkreise zu setzen,
nachdem gewünschte Daten in den ersten (20-1, ..., 20-3) und zweiten (30-1, ..., 30-3) Speicherabschnitten und den Diagnoseeingangsmustererzeugungs- und Endsignalerzeugungsschaltkreisen (40-1, ..., 40-3) gesetzt worden sind, das Abtastbetriebsmodusssignal freigegeben wird, wodurch selektiv ein spezifischer der Logikschaltungsblöcke diagnostiziert wird.

5. Selbstdiagnoseschaltkreis nach Anspruch 1, dadurch gekennzeichnet, daß jeder der Logikschaltungsblöcke einen Diagnoseeingangsmustererzeugungs-, Endsignalerzeugungs- und Diagnoseergebnisübertragungssignalerzeugungsschaltkreis (41-1, ..., 41-3) aufweist, wobei jeder Logikschaltungsblock gemäß dem Endsignal diagnostiziert wird, das von einem anderen der Schaltungsblöcke gesendet wird, die vor dem fraglichen Schaltungsblock angeordnet sind;
der erste Speicherabschnitt (20-1, ..., 20-3) darin zu haltende Eingangssignale gemäß einem Abtastbetriebsmodussignal (T) auswählt;
der zweite Speicherabschnitt (51) ein lineares rückgekoppeltes Schieberegister mit seriellen Eingängen umfaßt; und
ein Abtastkettenschaltkreis zum Verbinden der ersten Speicherabschnitte (20-1, ..., 20-3) und der Diagnoseeingangsmustererzeugungs-, Endsignalerzeugungs- und Diagnoseergebnisübertragungssignalerzeugungsschaltkreise (41-1-, ..., 41-3) in einer vorbestimmten Reihenfolge vorgesehen ist,
Abtastdaten durch den Abtastkettenschaltkreis geliefert werden, um Daten in dem ersten Speicherabschnitt (20-1, 20-3) und den Diagnoseeingangsmustererzeugungs-, Endsignalerzeugungs- und Diagnoseergebnisübertragungssignalerzeugungsschaltkreisen (41-1, ..., 41-3) zu setzen,
nachdem gewünschte Daten an den ersten Speicherabschnitt (20-1, ..., 20-3) und die
Diagnoseeingangsmustererzeugungs-, Endsignalerzeugungs- und Diagnoseergebnisübertragungssignalerzeugungsschaltkreise (41-1, ..., 41-3) gesendet worden sind, das Abtastbetriebsmodussignal (T) freigegeben wird und die Diagnoseergebnisse jeweiliger Schaltungsblöcke an den zweiten Speicherabschnitt (51) übertragen werden, wodurch selektiv ein spezifischer der Schaltungsblöcke diagnostiziert wird.

## Revendications

1. Circuit d'auto-diagnostic comprenant :
une pluralité de blocs de circuit logique (1-1, ..., 1-3) à diagnostiquer ;
une pluralité de premières parties de stockage (20-1, ..., 20-3), chaque première partie de stockage étant couplée à un bloc de circuit logique respectif et présentant une sortie indiquant que ledit circuit logique respectif auquel elle est couplée doit réaliser une opération d'auto-diagnostic ;
une pluralité de secondes parties de stockage (30-1, ..., 30-3), chaque seconde partie de stockage étant couplée à un bloc de circuit logique respectif (1-1, ..., 1-3) pour stocker des résultats de diagnostic desdits blocs de circuit logique respectifs ;
une voie de balayage incluant ladite pluralité de premières (20-1, ..., 20-3) et de secondes (30-1, ..., 30-3) parties de stockage et un moyen pour valider sélectivement des blocs de circuit logique particuliers afin de réaliser un mode opératoire de diagnostic séquentiel dans lequel lesdits blocs de circuit logique (1-1, ..., 1-3) sont séquentiellement diagnostiqués, et un mode diagnostic sélectif dans lequel un bloc de circuit logique spécifique est sélectivement diagnostiqué si une valeur logique particulière d'un signal de démarrage de diagnostic est appliquée et si des données d'entrée en balayage pour diagnostiquer sélectivement le bloc de circuit spécifique ont été appliquées dans un mode opératoire d'entrée en balayage.

2. Circuit d'auto-diagnostic selon la revendication 1, dans lequel chacun desdits blocs de circuit logique (1-1, ..., 1-3) est muni d'un circuit de génération de motif d'entrée de diagnostic et de génération de signal de fin (40-1, ..., 40-3) qui peut être établi dans un état opératoire de diagnostic conformément à une donnée d'entrée en balayage pour diagnostiquer sélectivement ledit bloc de circuit logique particulier.

3. Circuit d'auto-diagnostic selon la revendication 2, comprenant en outre :
un circuit de chaîne de balayage pour connecter lesdites premières et secondes parties de stockage et lesdits blocs de circuit logique selon l'ordre prédéterminé ;
un moyen pour mettre en oeuvre un mode opératoire de balayage par l'intermédiaire dudit circuit de chaîne de balayage et pour établir des données dans lesdites premières (20-1, ..., 20-3) et secondes (30-1, ..., 30-3) parties de stockage et dans les circuits de génération de motif d'entrée de diagnostic et de génération de signal de fin (40-1, ..., 40-3) de telle sorte que l'un particulier desdits blocs de circuit logique soit diagnostiqué sélectivement puis pour libérer ledit mode opératoire de balayage.

4. Circuit d'auto-diagnostic selon la revendication 1, dans lequel chacun desdits blocs de circuit logique (1-1, ..., 1-3) comporte un circuit de génération de motif d'entrée de diagnostic et de génération de signal de fin (40-1, ..., 40-3), chaque bloc de circuit logique étant diagnostiqué conformément au signal de fin envoyé depuis un autre desdits blocs de circuit logique (1-1, ..., 1-3) agencé à l'avant dudit bloc de circuit logique en question ;
lesdites premières (20-1, ..., 20-3) et secondes (30-1, ..., 30-3) parties de stockage sélectionnent des signaux d'entrée destinés à être bloqués dedans conformément à un signal de mode opératoire de balayage ; et
un circuit de chaîne de balayage est prévu pour connecter lesdites premières et secondes parties de stockage et lesdits circuits de génération de motif d'entrée de diagnostic et de génération de signal de fin (40-1, ..., 40-3) selon un ordre prédéterminé ;
des données d'entrée en balayage sont appliquées par l'intermédiaire dudit circuit de chaîne de balayage sur lesdites premières et secondes parties de stockage et sur lesdits circuits de génération de motif d'entrée de diagnostic et de génération de signal de fin pour établir des données dans lesdites parties de stockage et lesdits circuits de génération de motif d'entrée de diagnostic et de génération de signal de fin,
après que des données souhaitées ont été établies dans lesdites premières (20-1, ..., 20-3) et secondes (30-1, ..., 30-3) parties de stockage et dans lesdits circuits de génération de motif de fin d'entrée de diagnostic et de génération de signal de fin (40-1, ..., 40-3), le signal de mode opératoire de balayage est libéré, d'où le diagnostic sélectif de l'un spécifique desdits blocs de circuit logique.

5. Circuit d'auto-diagnostic selon la revendication 1, dans lequel chacun desdits blocs de circuit logique comporte un circuit de génération de motif d'entrée de diagnostic, de génération de signal de fin et de génération de signal de transfert de résultat de diagnostic (41-1, ..., 41-3), chaque bloc de circuit logique étant diagnostiqué conformément au signal de fin envoyé depuis un autre desdits blocs de circuit agencé à l'avant du bloc de circuit en question ;
ladite première partie de stockage (20-1, ..., 20-3) sélectionne des signaux d'entrée destinés à être bloqués en son sein conformément à un signal de mode opératoire de balayage (T) ;
ladite seconde partie de stockage (51) comprend un registre à décalage à retour linéaire muni d'entrées série ; et
un circuit de chaîne de balayage est prévu pour connecter lesdites premières parties de stockage (20-1, ..., 20-3) et lesdits circuits de génération de motif d'entrée de diagnostic, de génération de signal de fin et de génération de signal de transfert de résultat de diagnostic (41-1,..., 41-3) selon un ordre prédéterminé ;
des données d'entrée en balayage sont appliquées par l'intermédiaire dudit circuit de chaîne de balayage pour établir des données dans ladite première partie de stockage (20-1, ..., 20-3) et lesdits circuits de génération de motif d'entrée de diagnostic, de génération de signal de fin et de génération de signal de transfert de résultat de diagnostic (41-1, ..., 41-3), après que des données souhaitées ont été envoyées sur ladite première partie de stockage (20-1, ..., 20-3) et sur lesdits circuits de génération de motif d'entrée de diagnostic, de génération de signal de fin et de génération de signal de transfert de résultat de diagnostic (41-1, ..., 41-3), après que le signal de mode opératoire de balayage (T) a été libéré et après que les résultats des diagnostics des blocs de circuit respectifs sont transférés dans ladite seconde partie de stockage (51), d'où le diagnostic sélectif de l'un spécifique desdits blocs de circuit.
